# EUROPEAN PATENT SPECIFICATION

(11) **EP 0 431 490 B1**
(45) Date of publication and mention of the grant of the patent: **26.10.1994**
(21) Application number: 90122955.9
(22) Date of filing: 30.11.1990
(51) Int. Cl.: H01L 23/485, H01L 27/118

(54) **Semiconductor integrated circuit device having pads at periphery of semiconductor chip**
Integrierte Halbleiterschaltungsvorrichtung mit Kontaktierungsflächen am Rande des Halbleiterchips
Dispositif de circuit intégré semi-conducteur comprenant des plats de jonction à la périphérie de la puce semi-conductrice

(30) Priority: 02.12.1989 JP 312276/89
(43) Date of publication of application: 12.06.1991
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Tanaka, Yasunori, c/o Intellectual Property Div., Tokyo 105 (JP); Ogawa, Kyohsuke, c/o Intellectual Property Div., Tokyo 105 (JP)
(74) Representative: Lehn, Werner, Dipl.-Ing.

(56) References cited:
- FR-A- 2 508 255
- PATENT ABSTRACTS OF JAPAN, vol. 9, no. 204 (E-337)[1927], 21st August 1985 & JP-A-60 070 742
- PATENT ABSTRACTS OF JAPAN, vol. 10, no. 24 (E-377)[2081], 30th January 1986 & JP-A-60 182 756
- PATENT ABSTRACTS OF JAPAN, vol. 10, no. 275 (E-438)[2331], 18th September 1986 & JP-A-61 097 852

## Description

The present invention relates to a semiconductor integrated circuit device including a semiconductor chip having a plurality of electrical connection pads which are arranged in at least first and second rows at peripheral portions of the chip such that the first row of pads is disposed at the outside portion of the chip and the second row of pads is located inside the first row of pads.

Recently, fine pattern technolgies of semiconductor devices have been rapidly developed, and the integration density of the semiconductor integrated circuit device (hereinafter referred to as "an LSI") has increased. When the integration density of the LSI is raised, high function and multi-function LSIs are naturally manufactured as products.

However, the high function and multi-function LSIs require more electric means for connecting the exterior of the device to the interior of the device. In other words, the LSI necessitates a number of pads.

Then, the arrangement of the pads in the conventional LSI will be considered.

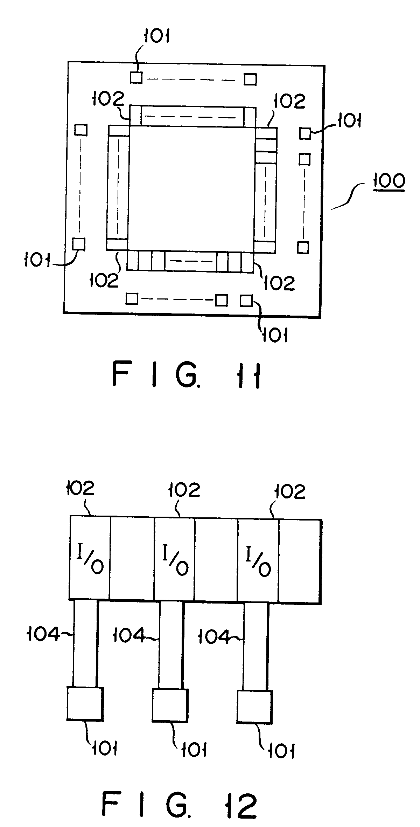

Fig. 11 is a plan view showing the most general conventional LSI. In the drawing, a reference numeral 100 denotes an LSI chip, and pads 101 to be electrically connected to external terminals of a lead frame are arranged in one row along four sides of the chip. A so-called I/O circuits 102 of circuits for providing the LSI are also formed in one row inside the rows of the pad 101. Fig. 12 is an enlarged view of the vicinity of the pads of the LSI shown in Fig. 11. In Fig. 12, it is understood that the I/O circuits 102 and the pads 101 are disposed at a predetermined pitch and are connected through interconnection layers 104 with one another.

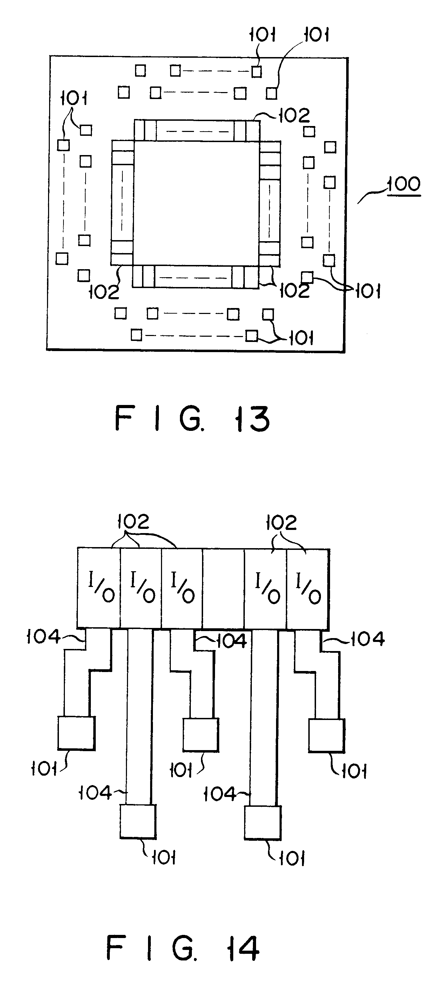

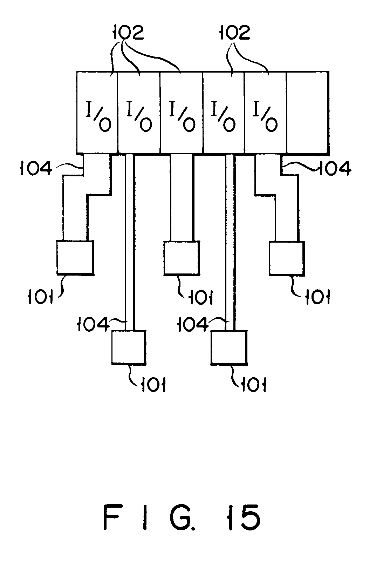

Further, a plan view of fig. 13 shows an LSI which has been proposed in order to increase the number of pads 101 while suppressing its area. In fig. 13, reference numerals correspond to those in Fig. 11. In other words, the pads 101 are zigzag arranged to suppress both an increase in the pads 101 and an increase in the area of the LSI due to the increase in the pads 101. Fig. 14 is an enlarged view showing the vicinity of pads 101 of the LSI illustrated in Fig. 13. However, it is not still improved to suppress the increase in the area of the LSI. Fig. 15 shows an LSI which has been proposed in order to further suppress the increase in the area, illustrating an enlarged view of the vicinity of the pads thereof. That is, in the LSI with the zigzag arranged pads shown in Fig. 15, the width of interconnection layers 104 passing among pads 101 is reduced to suppress the increase in the area. However, in such an LSI, the reliability of the interconnection layers 104 may be lowered because the width of each interconnection layer is reduced. That is, since the current density following through interconnection layers 104 is increased, an unwanted electromigration may occur.

From Patent Abstract of Japan 9 (204), (E-337) [1927] a semiconductor device is known having a plurality of pads arranged in first and second rows at the peripheral portions of a semiconductor chip such that the first row of pads are disposed at the outside portion of the chip and the second row of pads are located inside the first row of pads.

From FR-A-2 508 225 a semiconductor device is known wherein peripheral bonding pads are connected to internal circuits using multilevel interconnection means.

Accordingly, it is an object of the present invention to provide a semiconductor integrated circuit device having an improved interconnection means electrically connecting internal circuity to the pads.

According to the present invention, there is provided a semiconductor integrated circuit device including a semiconductor chip having a plurality of electrical connection pads which are arranged in at least first and second rows at peripheral portions of the chip such that the first row of pads is disposed at the outside portion of the chip and the second row of pads is located inside the first row of pads, characterized in that I/O circuits are arranged in a row inside the second row of pads, and multilevel interconnection means including at least first and second interconnection layers connected to the I/O circuits and separated from one another by an interlevel insulator are electrically connected to the pads of the first and second rows, respectively, whereby the first interconnection layers are provided below the second interconnection layers.

The pads to be connected to external terminals such as leads of a lead framed are increased without increasing the area of the chip.

The invention together with advantages thereof may best be understood by reference to the following description and accompanying drawings in which:
Fig. 1 is a plan view showing a semiconductor integrated circuit device according to a first embodiment of the present invention;
Fig. 2 is a partly enlarged plan view showing pads of the semicondutor integrated circuit device according to the first embodiment;
Fig. 3 is a sectional view taken along a line A-A′ of Fig. 2;
Fig. 4 is a partly enlarged plan view showing pads of a semiconductor integrated circuit device according to a second embodiment of the present invention;
Fig. 5 is a plan view showing an interconnection structure in the semiconductor integrated circuit device of the present invention;
Fig. 6 is a partly enlarged plan view showing pads of a semiconductor integrated circuit device according to a third embodiment of the present invention;
Fig. 7 is a sectional view taken along a line B-B′ of Fig. 6;
Fig. 8 is a partly enlarged plan view showing pads of a semiconductor integrated circuit device according to a fourth embodiment of the present invention;
Fig. 9 is a plan view showing a semiconductor integrated circuit according to a fifth embodiment of the present invention;
Fig. 10 is a partly enlarged plan view showing pads of the semiconductor integrated circuit device according to fifth embodiment of the present invention;
Fig. 11 is a plan view showing a conventional first semiconductor integrated circuit device;
Fig. 12 is a partly enlarged plan view showing pads of the conventional first semiconductor integrated circuit device;
Fig. 13 is a plan view showing a conventional second semiconductor integrated circuit device;
Fig. 14 is a partly enlarged plan view showing pads of the conventional second semiconductor integrated circuit device; and
Fig. 15 is a partly enlarged plan view showing pads of the conventional second semiconductor integrated circuit.

A semiconductor integrated circuit device according to embodiments of the present invention will be described with reference to the accompanying drawings.

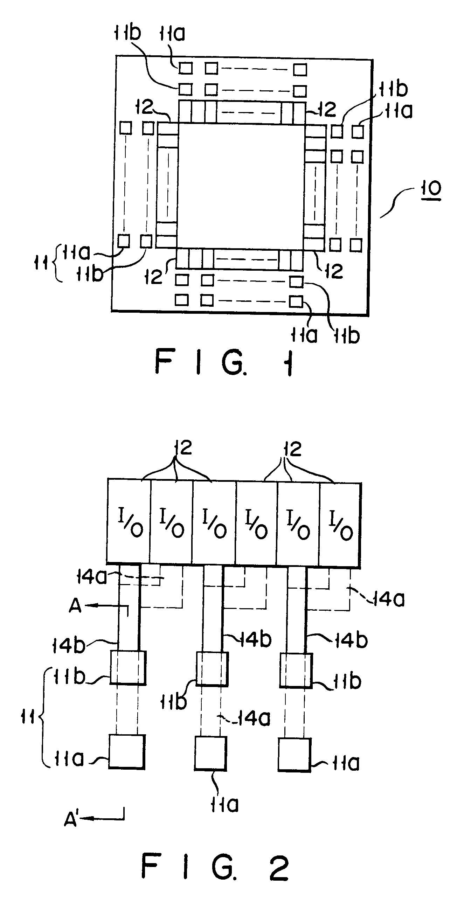

Fig. 1 is a plan view schematically showing a semiconductor integrated circuit device according to a first embodiment of the invention.

In Fig. 1, a reference numeral 10 denotes an LSI chip. The LSI chip has pads 11 (11a, 11b), which are electrically connected to external terminals of a lead frame and arranged in two rows at the periphery along four sides thereof. That is, the pads 11a provide a first row disposed at the outside portion of the chip, while the pads 11b render a second row located inside the first row of the pads 11a. The arrangement of the pads 11 has a structure which includes the first row of the pads 11a and the second row of the pads 11b. So-called I/O circuits 12 in circuits for providing the LSI are arranged in one row inside the second row of the pads 11b.

Fig. 2 is an enlarged view of the vicinity of the pads 11 of the LSI shown in Fig. 1.

In Fig. 2, the I/O circuits 12 and the pads 11 are disposed at a predetermined pitch. As described above, the pads 11 are arranged in the two rows provided by the first row of the pads 11a and the second row of the pads 11b, and the total number of the pads 11 is increased. These pads 11 are disposed at a minimum interval to perform a minimum pad forming area to be obtained by the maximum number of the pads 11. In other words, the pads 11 are disposed in such a manner that a more decrease in the pad forming area cannot be obtained. In a multilevel interconnection structure for providing the arrangement of pads, interconnection layers 14a connected to pads 11a disposed at the most outside portion of the chip are provided by first wiring layers located at a deep position from the surface of the device. On the other hand, interconnection layers 14b connected to the pads 11b disposed inside the pads 11a are provided by second wiring layers located at a shallower position than the first wiring layers.

Thus, unwanted short circuit between first and second wiring layers can be prevented.

This considers that when the pads 11 are subjected to wire bonding, a damage of the wiring layers is increased as the position becomes shallow.

More specifically, according to the present invention, the interconnection layers 14a connected to the pads 11a are provided by the first wiring layers basically located at the deep position.

Thus, the damage of the interconnection layers 14a may be reduced during the wire bonding.

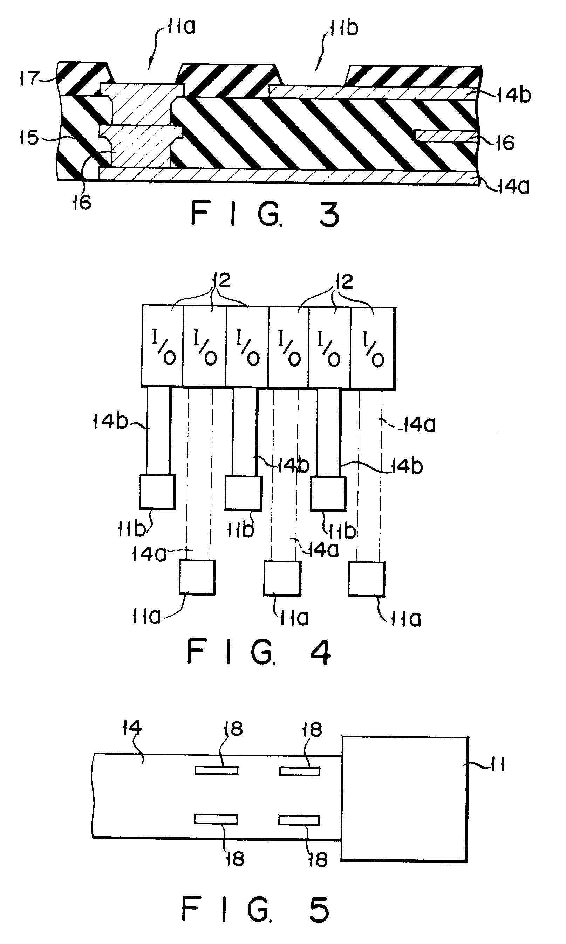

In relation to this point, the present invention further provides a consideration, which will be described with reference to Fig. 3.

Fig. 3 is a sectional view taken along a line A-A' of Fig. 2. As shown in Fig. 3, the interconnection layer 14a formed on the surface of the LSI chip is provided by a first wiring layer. A buffer layer 16 of a conductive material is provided above the interconnection layer 14a through an interlevel insulator 15. As a second wiring layer, the interconnection layer 14b is provided above the buffer layer 16 through the interlevel insulator 15.

More specifically, the consideration is that the buffer layer 16 is provided between first and second interconnection layers.

As described above, since the buffer layer 16 is provided in in the multilevel interconnection structure, the first wiring layer can be formed at the deep position from the surface of the device to dispose the interconnection layer 14a at the deep position. Thus, the interconnection layers 14a may be prevented from the unwanted damage during the wire bonding.

Various advantages due to the buffer layer 16 are provided. As a typical example, the step coverage of a contact layer (conductive layer) can be improved when it is formed in a contact hole for the internal interconnection layer 14a formed at the deep position from the surface of the device.

When the contact hole is formed in the interlevel insulator at the deep position, the aspect ratio of the contact hole generally tends to increase. If the aspect ratio is increased, the step coverage of the contact layer is deteriorated as known in the art.

Particularly, in the case of the pads subjected to the wire bonding, it is required to provide contact layers having high surface planarity. To this end, a contact layer to become the pad 11a must have a preferable step coverage for the contact hole. In order that the contact layer has the preferable step coverage for the contact hole, it is important to reduce the aspect ratio as low as possible.

Therefore, if the buffer layer 16 described above is provided between first and second wiring layers, the contact hole is once buried with the buffer layer 16. Consequently, a depth of a contact hole to be next formed can be adjusted. If the depth of the contact hole is adjusted, the aspect ratio of the contact hole may be controlled.

Accordingly, the step coverage for the contact hole of the contact layer may be improved by adjusting the depth of the contact hole so that the aspect ratio becomes as low as possible.

The buffer layer 16 is not limited to one layer. Two or more layers may be employed in the semiconductor integrated circuit device according to the present invention if necessary.

Even if the buffer layer 16 is not especially provided for the purpose of the above described object, interconnection layers used in internal circuits of the LSI may be employed.

Further, in the multilevel interconnection structure, a desired pattern may be provided to each interconnection layer.

As a result, it is not necessary to excessively reduce the width of interconnection layers (e.g., 14a 14b shown in Fig. 2). Therefore, it may be possible to control the current density flowing through each interconnection layer.

Consequently, the decrease in the reliability of the interconnection structure and particularly the decrease in the reliability related to the electromigration can be prevented.

A method of making the device of the first embodiment and hence a method of forming the pads (11a, 11b) will be described with reference to Fig. 3.

Though not shown in Fig. 3, the interconnection layer 14a (the first wiring layer) is provided on an insulating layer formed on the chip. A first metal film for the first interconnection layer is deposited on the insulating layer (not shown) by, for example, sputtering techniques, and then patterned to a desired configuration by photoetching techniques, thereby providing the interconnection layer 14a on the insulating layer. Then, a first insulating film for the interlevel insulator 15 is deposited on the whole surface including the interconnection layer 14a by, for example, CVD techniques. Thereafter, a first contact hole is formed in the first insulating film by photoetching techniques so as to reach the interconnection layer 14a. A second metal film is deposited on the whole surface including the first contact hole by, for example, sputtering techniques, and then patterned by photoetching techniques, thereby providing the buffer layer 16 and the first contact layer (denoted by 16) buried in the first contact hole at the same time. Thereafter, a second insulating film for the interlevel insulator 15 is deposited on the whole surface by, for example, CVD techniques, and a second contact hole reaching the contact layer is cut in the second insulating film by photoetching techniques. At this time, the aspect ratio of the second contact hole is adjusted as described above to improve the step coverage of a the second contact layer to be formed in the second contact hole. A third metal film for the interconnection layer 14b (second wiring layer) is deposited on the whole surface by, for example, sputtering techniques, and then patterned by photoetching techniques, thereby providing the interconnection layer 14b and the second contact layer buried in the second contact hole. Subsequently, a surface passivation film 17 is formed on the whole surface by, for example, CVD techniques, and third contact holes is then cut in the surface passivation film 17 by photoetching techniques so as to reach both the interconnection layer 14b and the second contact layer. Consequently, the pads 11a and 11b are provided.

As the arrangement pattern of pads 11 according to the invention, a zigzag arrangement type pattern may be employed instead of the arrangement pattern shown in Fig. 1. Such an example is shown as a second embodiment in Fig. 4. In the drawing, reference numerals correspond to those in Fig. 2.

As shown in Fig. 4, the chip (not shown) includes pads 11a arranged in a first row and pads 11b arranged in a second row. The first row is disposed at the most outside portion of the chip and shifted from the second row by a predetermined distance to provide the zigzag arrangement type pattern.

In this case, the interconnection structure has the multilevel wiring structure in the same manner as the first embodiment. The interconnection layers 14a connected to the pads 11a of the first row are provided by the first wiring layers disposed at the deepest position from the device surface. The interconnection layers 14b connected to the pads 11b of the second row are also provided by the second wiring layers disposed at the shallower position than the first wiring layers.

Accordingly, the advantage of reducing the damage caused during the wire bonding can be also provided

In the second embodiment, since the pads 11 (11a, 11b) are arranged at a minimum interval, the zigzag arrangement pattern can realize the minimum pad forming area obtained by the maximum number of pads 11.

Further, buffer layers 16 may be provided between the interconnection layer 14a of the first wiring layer and the interconnection layer 14b of the second wiring layer as shown in Fig. 3.

The arrangement of the pads and the wiring structure in the semiconductor integrated circuit device according to the present invention have been described.

However, when an LSI chip, i.e., a semiconductor integrated circuit chip with circuit elements is sealed with resin, it becomes a problem that unwanted cracks are caused in the surface passivation film (insulating layer). If cracks occur in the surface passivation film of the chip, the reliability of the semiconductor integrated circuit device itself may be lowered, and its manufacturing yield may be decreased to raise the cost of products.

In may be considered that the cause of the cracks depends upon a difference between the thermal expansion coefficients of the chip and the molded resin. The cracks are remarkably caused at the peripheral edge of the chip. Therefore, it may be presume that the cracks are affected by the thermal expansion coefficient of the contact layers for providing the pads.

In the semiconductor integrated circuit device according to the present invention, a great number of pads are employed as described above, and disposed densely in the narrow area.

Therefore, it is desirable to provide any counter-measure for preventing the problem of the cracks to suppress the decrease in the reliability.

Then, means for suppressing the decrease in the reliability due to the cracks of the semiconductor integrated circuit device according to the present invention will now be described.

In order to solve the problem of the cracks caused in the surface passivation film of the LSI chip, it is important how to reduce a stress generated due to the difference between thermal expansion coefficients of the molded resin and the LSI chip. Since the surface passivation film is interposed between the interconnection layers and the molded resin in the vicinity of the contact layers for providing the pads, materials with different thermal expansion coefficients are densely disposed in such a region that the width in the depth direction is relatively narrow. As the cracks frequently occur at such positions, it is considered to be most effective to reduce the stress produced due to the difference between the thermal expansion coefficients of the material densely disposed thereat.

Therefore, at least one interconnection layer is provided by a structure as shown in Fig. 5. In the drawing, a reference numeral 14 denotes the interconnection layer, and the pad 11 is disposed at the end. Slits 18 are provided in the interconnection layer 14.

As described above, the slits 18 are provided in the interconnection layer 14, and particularly in the interconnection layer 14b near the surface, thereby dispersing the stress produced particularly in the surface passivation film due to the difference of the thermal expansion coefficients.

Therefore, in the surface passivation film of the LSI chip, for example, the surface passivation film 17 shown in Fig. 3, the cracks may be effectively prevented. Particularly in the semiconductor integrated circuit device having a great number of pads according to the present invention, the decrease in the reliability of the device itself may be suppressed.

The structure in which the pads are disposed in two rows as shown in the first and second embodiments has been essentially described in detail. However, the arrangement of the pads are not limited to the double row, but may be arranged in three or more rows.

Pads arranged in three rows will be described as a third embodiment.

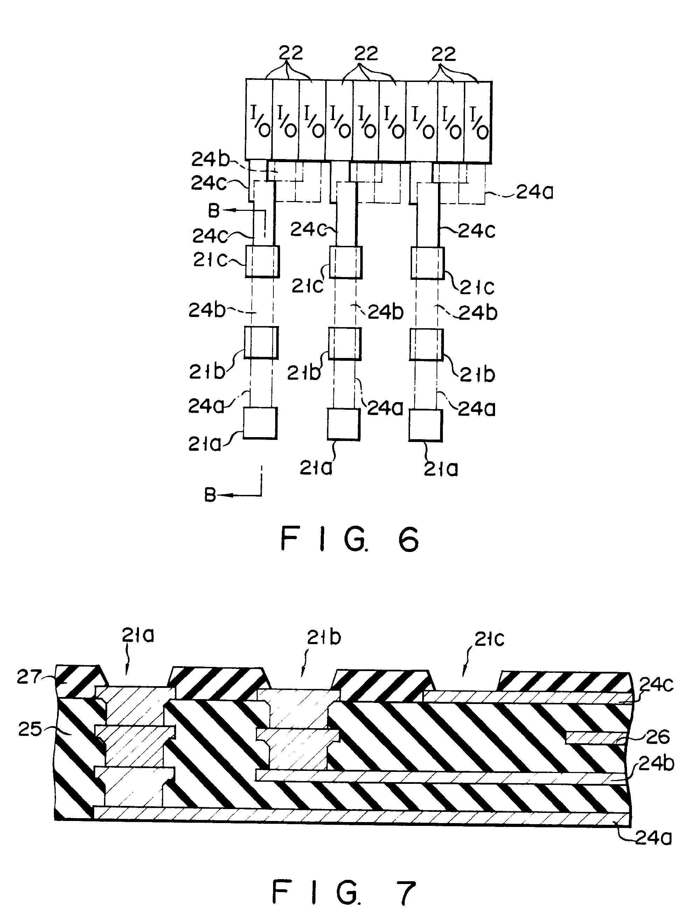

Fig 6 is a plan view schematically showing an arrangement of pads of a semiconductor integrated circuit device according to the third embodiment of the present invention and particularly illustrating an enlarged plan view of the vicinity of pads.

The the device of the third embodiment has the similar plane configuration to the device shown in Fig. 1 except the arrangement of pads, and hence a drawing for the entire plane configuration will be omitted.

As shown in Fig. 6, I/O circuits 22 and pads 21 (21a, 21b, 21c) are arranged at a predetermined pitch in the same manner as the first embodiment. The pads 21 are arranged in triple rows which include a first row of the pads 21a, a second row of the pads 21b and a third row of the pads 21c. The total number of the pads 21 is further increased as compared with that of the first embodiment. In this embodiment, the pads 21 are disposed at the minimum interval, and the minimum pad forming area to be obtained in the maximum number of the pads 21 is performed. In a multilevel interconnection structure for providing the arrangement of pads, interconnection layers 24a, which are connected to pads 21a disposed at the most outside portion of the chip, are provided by first wiring layers formed at the deep position from the surface of the device. Interconnection layers 24b connected to the pads 21b disposed inside the pads 21a are formed of second wiring layers provided at a shallower position than the first wiring layers, and interconnection layers 24c connected to the pads 21c disposed inside the pads 21b are formed of third wiring layers provided at a shallower position than the second wiring layers. Therefore, an unwanted damage of the interconnection layers 24a and 24b may be reduced during the wire bonding.

Fig. 7 is a view taken along a line B-B′ of Fig. 6. As shown in the drawing, even in the third embodiment, a buffer layer 26 may be provided similarly to the first embodiment, between the third wiring layer (interconnection layer 24c) and the second wiring layer (interconnection layer 24b). Accordingly, the first wiring layers can be provided at the deeper position from the surface of the device, thereby reducing the damage of the interconnection layers 24a during the wire bonding.

Further, when contact holes reaching the first wiring layer (interconnection layer 24a) and the second wiring layer (interconnection layer 24b) are cut in the interlevel insulator 25, a buffer layer 26 is provided to adjust the depth of the contact hole and the aspect ratio.

Therefore, the step coverage for the contact holes of the second wiring layers can be improved by adjusting the depth so as to reduce the aspect ratio as low as possible.

Further, in the third embodiment as shown in Fig. 7, the aspect ratio of the contact hole reaching the first wiring layer (24a) can be adjusted by the second interconnection layer (24b).

The pads 21c are provided by depositing a metal film for the third wiring layer (interconnection layer 24c) on the interlevel insulator 25, patterning the deposited metal film to form the arrangement of pads and the interconnection layers 24c, depositing a surface passivation film 27 on the surface, and forming contact holes in the passsivation film 27 to expose the interconnection layers 24c, respectively.

A buffer layer having a similar function to that of the buffer layer 26 may be formed between the first wiring layer (24a) and the second wiring layer (24b).

This is because the first wiring layer (24a) is indispensably formed at the sufficiently deep position from the surface of the device due to the three-layer interconnection structure, so that the damage of the interconnection layers 24a can be reduced during the wire bonding.

In the third embodiment described above, the multi-level interconnection layers 24a, 24b, 24c connected to the pads 21a, 21b, 21c arranged in three rows are provided by the three-level interconnection layers, but they may also be provided by the two-level interconnection layers.

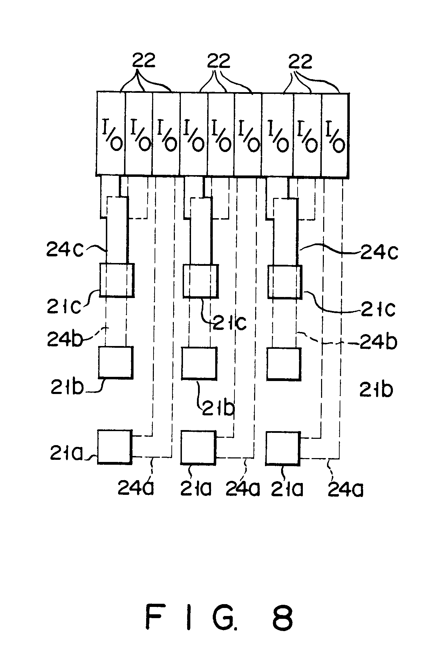

Such an example will be described as a fourth embodiment with reference to Fig. 8.

Fig. 8 schematically shows a structure of a semiconductor integrated circuit device according to a fourth embodiment, and particularly shows an enlarged plan view of the vicinity of pads. In Fig. 8, reference numerals correspond to those in Fig. 7.

As shown in Fig. 8, if wiring patterns are provided in such a manner that interconnection layers 24a connected to pads 21a do not intersect with interconnection layers 24b connected to pads 21b, the interconnection layers 24a and 24b may be formed by the wiring layers having the same level. In this example, they are provided by the first wiring layers formed on the chip surface.

It has been required to increase the number of pads in LSIs, depending upon requirement for LSIs having the high function and multifunction. In addition, terminals for testing functions of LSIs have been desired. If LSIs have the high function and multifunction, the number of internal circuits may be naturally increased. If the number of the internal circuits is increased, functional test patterns for considering the connection among of the internal circuits may be increased.

Therefore, when functional test terminals for only the internal circuits are provided, it may not be necessary to particularly consider the connection among the internal circuits, and it may be possible to provide test patterns for carrying out functional tests of desired circuits.

From the foregoing description, when the functional test terminals are present, the quantity of the functional test patterns may be considerably reduced.

Further, if undesired faults occur in LSIs having the functional test terminals for testing only the internal circuits, it may be possible to monitor the operating conditions of the internal circuits. Consequently, it may be easy to find faulty internal circuits.

Form the above-described point of view, the functional test terminals have been greatly required for LSIs. however, if the LSI is intended to separately provide the functional test terminals, the number of pads may be increased to increase the area of the LSI. According to the vicious cycle, it has been negative in the LSIs to adopt the functional test terminals.

However, according to the semiconductor integrated circuit device of the present invention, the increase in the area is suppressed to increase the number of pads. Therefore, an optimum structure may be provided to adopt the functional test terminals.

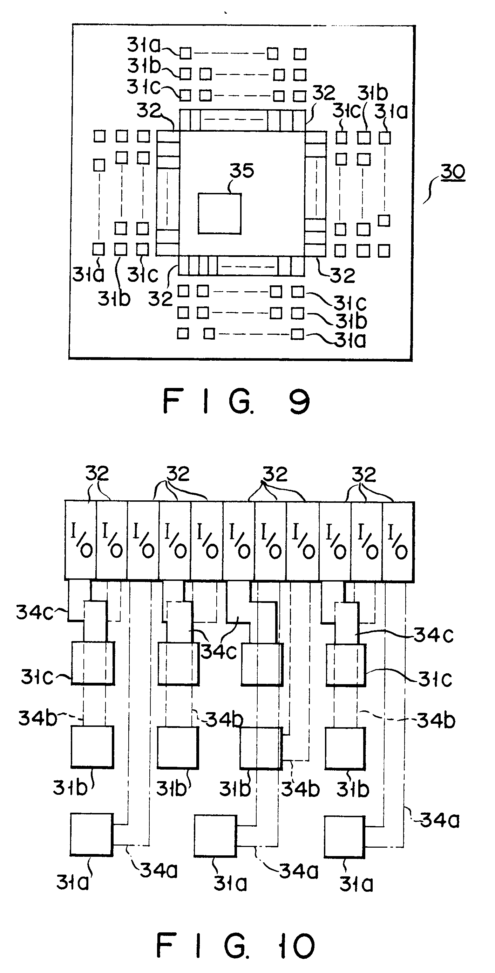

An example of a semiconductor integrated circuit device according to the present invention provided with the functional test terminals will be described as a fifth embodiment with reference to Figs. 9 and 10.

Fig. 9 is a plan view schematically showing a semiconductor integrated circuit device according to the fifth embodiment of the present invention.

In Fig. 9, a reference numeral 30 denotes an LSI chip. Pads 31 (31a, 31b, 31c) electrically connected to external terminals of a lead frame are arranged in three rows at a periphery of the chip along four sides thereof. I/O circuits 32 in circuits for providing an LSI is arranged in one row which is disposed inside the row of the pads 31c arranged at the most inside portion of the chip. An internal circuit 35 is shown in the chip.

Fig. 10 is an enlarged view of the vicinity of the pads 31 of the LSI shown in Fig. 9.

In this case, the row of pads 31a and the rows of pads 31b, 31c are arranged at a different arrangement pitch. This is because bonding wires are connected to the row of pads 31a, while the rows of 31b and 31c are used as functional test terminals.

It is unnecessary to connect bonding wires to the functional test terminals.

Therefore, it may be possible to reduce the arrangement pitch of the rows of 31b, 31c as compared with that of pads 31a.

Interconnection layers 34a connected to the pads 31a are provided by first wiring layers. Similarly, interconnection layers 34b and 34c connected to the pads 31b and 31c are provided by second and third wiring layers, respectively. The positions of the first to third wiring layers are such that the wiring layers connected to the pads disposed at the outside is provided at the deepest position, and the residual wiring layers are sucessively provided at shallower positions as they are connected to rows of pads arranged at the inside portions.

As described above, the present invention can provide functional test terminals without difficulty.

When the pads to become the functional test terminals are provided, the existing bonding machine can be used as it is, and the pads 31a disposed at the most outside portions are desirably electrically connected to the external terminals.

In the semiconductor integrated circuit device as described above, since a plurality of the pads disposed at the periphery of the semiconductor integrated circuit chip are arranged in double or more rows toward the edge of the chip, the number of the pads can be increased. Further, since at least two wiring layers for providing the internal interconnection layers for electrically connecting the pads to the internal circuits are provided, desired wiring layers for providing interconnection layers can be selected in respective pads, and also prevented from the unwanted short circuit.

Since the multilevel interconnection layers connected to pads include wiring layer provided at the deep position from the surface of the device, the damage can be reduced during the wire bonding.

More specifically, since the interconnection layers can be formed directly under the pads, the increase in the area of the semiconductor integrated circuit device can be further suppressed.

The wiring layers with at least two-layer structure can be provided in such a manner that each of them has a desired pattern. As a result, it can not be required to reduce the width of each interconnection layer provided by each wiring layer, and it can be possible to sufficiently control the current density flowing through each interconnection layer. consequently, the reliability of the multilevel interconnection structure may not be lowered.

Reference signs in the claims are intended for better understanding and shall not limit the scope.

## Claims

1. A semiconductor integrated circuit device including a semiconductor chip (10) having a plurality of electrical connection pads (11) which are arranged in at least first and second rows at peripheral portions of the chip (10) such that the first row of pads (11a) is disposed at the outside portion of the chip (10) and the second row of pads (11b) is located inside the first row of pads (11a),
***characterized in that***
I/O circuits (12) are arranged in a row inside the second row of pads (11b), and multilevel interconnection means including at least first and second interconnection layers (14a, 14b) connected to the I/O circuits and separated from one another by an interlevel insulator (15) are electrically connected to the pads (11a, 11b) of the first and second rows, respectively, whereby the first interconnection layers (14a) are provided below the second interconnection layers (14b).

2. The device according to claim 1, characterized in that the interlevel insulator (15) includes a buffer layer (16) of a conductive material therein.

3. The device according to claim 1, characterized in that each of the second interconnection layers (14b) includes a plurality of slits (18) therein.

4. The device according to claim 1, characterized in that a third row of pads (11) is arranged inside said second row.

5. The device according to claim 4, characterized in that third interconnection layers (24c) are provided on said second interconnection layers (24b) with a further interlevel insulator interposed therebetween and are electrically connected to the pads (21a) (21b) (21c) of the third row.

6. The device according to claim 5, characterized in that the interlevel insulator (25) includes a buffer layer (26) of a conductive material therein.

## Patentansprüche

1. Integrierte Halbleiterschaltungseinrichtung, umfassend einen Halbleiterchip (10) mit einer Vielzahl von elektrischen Verbindungskontaktierungsflächen (11), die in wenigstens ersten und zweiten Zeilen an Umfangsabschnitten des Chips (10) so angeordnet sind, daß die erste Zeile von Kontaktierungsflächen (11a) an dem Außenseitenabschnitt des Chips (10) angeordnet ist und die zweite Zeile von Kontaktierungsflächen (11b) innerhalb der ersten Zeile von Kontaktierungsflächen (11a) angeordnet ist;
dadurch **gekennzeichnet,** daß
I/O-Schaltungen (12) in einer Zeile innerhalb der zweiten Zeile von Kontaktierungsflächen (11b) angeordnet sind, und eine Mehrfachniveau-Zwischenverbindungseinrichtung mit wenigstens ersten und zweiten Zwischenverbindungsschichten (14a, 14b), die mit den I/O-Schaltungen verbunden und voneinander durch einen Zwischenniveau-Isolator (15) getrennt sind, jeweils mit den Kontaktierungsflächen (11a, 11b) der ersten und zweiten Zeilen elektrisch verbunden ist, wobei die ersten Zwischenverbindungsschichten (14a) unterhalb der zweiten Zwischenverbindungsschichten (14b) vorgesehen sind.

2. Einrichtung nach Anspruch 1, dadurch gekennzeichnet, daß der Zwischenniveau-Isolator (15) eine Pufferschicht (16) aus einem leitenden Material darin umfaßt.

3. Einrichtung nach Anspruch 1, dadurch gekennzeichnet, dßa jede der zweiten Zwischenverbindungsschichten (14b) eine Vielzahl von Schlitzen (18) darin umfaßt.

4. Einrichtung nach Anspruch 1, dadurch gekennzeichnet, daß eine dritte Zeile von Kontaktierungsflächen innerhalb der zweiten Zeile angeordnet ist.

5. Einrichtung nach Anspruch 4, dadurch gekennzeichnet, daß dritte Zwischenverbindungsschichten (24c) auf den zweiten Zwischenverbindungsschichten (24b) mit einem dazwischenliegenden weiteren Zwischenniveau-Isolator vorgesehen und elektrisch mit den Kontaktierungsflächen (21a, 21b, 21c) der dritten Zeile elektrisch verbunden sind.

6. Einrichtung nach Anspruch 5, dadurch gekennzeichnet, daß der Zwischenniveau-Isolator (25) eine Pufferschicht (26) aus einem leitenden Material darin umfaßt.

## Revendications

1. Dispositif à circuit intégré à semi-conducteur comprenant une pastille semi-conductrice (10) ayant plusieurs plages (11) de connexion électrique qui sont disposées en au moins une première et une seconde ligne de parties périphériques de la pastille (10) afin que la première ligne de plages (11a) soit placée à la partie externe de la pastille (10) et que la seconde ligne de plages (11b) soit placée à l'intérieur de la première ligne de plages (11a),
caractérisé en ce que :
des circuits d'entrée-sortie (12) sont disposés en ligne à l'intérieur de la seconde ligne de plages (11b), et des interconnexions à plusieurs niveaux, comprenant au moins une première et une seconde couche d'interconnexion (14a, 14b) connectées aux circuits d'entrée-sortie et séparées l'une de l'autre par un isolateur (15) placé entre les niveaux, sont connectées électriquement aux plages (11a, 11b) de la première et de la seconde ligne respectivement, si bien que les premières couches d'interconnexion (14a) sont placées sous les secondes couches d'interconnexion (14b).

2. Dispositif selon la revendication 1, caractérisé en ce que l'isolateur (15) à plusieurs niveaux comporte une couche tampon incorporée (16) d'un matériau conducteur.

3. Dispositif selon la revendication 1, caractérisé en ce que chacune des secondes couches d'interconnexion (14b) comporte plusieurs fentes (18).

4. Dispositif selon la revendication 1, caractérisé en ce qu'une troisième ligne de plages (11) est disposée à l'intérieur de la seconde ligne.

5. Dispositif selon la revendication 4, caractérisé en ce que les troisièmes couches d'interconnexion (24c) placées sur les secondes couches d'interconnexion (24b) avec un isolateur supplémentaire interposé entre les couches sont connectées électriquement aux plages (21a, 21b, 21c) de la troisième ligne.

6. Dispositif selon la revendication 5, caractérisé en ce que l'isolateur (25) placé entre les niveaux comporte une couche tampon incorporée (26) d'un matériau conducteur.
